(19) Europäisches Patentamt / European Patent Office / Office européen des brevets

(11) **EP 3 098 654 B1**

(12) **EUROPÄISCHE PATENTSCHRIFT**

(45) Veröffentlichungstag und Bekanntmachung des Hinweises auf die Patenterteilung:
**21.08.2019 Patentblatt 2019/34**

(51) Int Cl.:
*G03F 7/20* (2006.01)     *G05D 19/02* (2006.01)
*F16F 15/00* (2006.01)

(21) Anmeldenummer: **15169675.4**

(22) Anmeldetag: **28.05.2015**

(54) **VERFAHREN ZUR REGELUNG EINES AKTIVEN SCHWINGUNGSISOLATIONSSYSTEMS**

METHOD FOR REGULATING AN ACTIVE VIBRATION INSULATION SYSTEM

PROCÉDÉ DE RÉGLAGE D'UN SYSTÈME ACTIF D'ISOLATION DES VIBRATIONS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**30.11.2016 Patentblatt 2016/48**

(73) Patentinhaber: **Integrated Dynamics Engineering GmbH**
**65479 Raunheim (DE)**

(72) Erfinder:
• **Hartgers, Han**
**55122 Mainz (DE)**
• **Riemann, Bernd**
**64285 Darmstadt (DE)**

(74) Vertreter: **Blumbach · Zinngrebe Patentanwälte PartG mbB**
**Alexandrastraße 5**
**65187 Wiesbaden (DE)**

(56) Entgegenhaltungen:
**US-A- 5 303 155     US-A1- 2003 090 645**
**US-B2- 7 216 018**

**Beschreibung**

Gebiet der Erfindung

Die Erfindung betrifft ein Verfahren zur Regelung eines aktiven Schwingungsisolationssystems, wie es insbesondere in der Waferprozessierung zur schwingungsisolierten Lagerung von Maschinen wie beispielsweise Lithographiegeräten, Wafer-Inspektionsgeräten etc. verwendet wird.

Hintergrund der Erfindung

Aus der Praxis bekannt sind aktive Schwingungsisolationssysteme, welche nach dem sogenannten Skyhook-Prinzip geregelt werden. Bei einem derartigen aktiv geregelten Schwingungsisolationssytem ist ein Sensor, welcher als Geschwindigkeits- oder Beschleunigungssensor, insbesondere welcher als Geophon ausgebildet ist, an der zu isolierenden Last, also beispielsweise an der zu isolierenden Maschine, angeordnet und misst über die Geschwindigkeit oder die Beschleunigung eine absolute Größe. Hierdurch wird über Ansteuerung von Aktoren eine aktive Dämpfung erzielt. Bei der Skyhook-Regelung wirkt die Dämpfung nicht zwischen dem Boden und der zu isolierenden Last, sondern zwischen der zu isolierenden Last und einem virtuellen Punkt im Raum, was den Vorteil nach sich zieht, dass Bodenschwingungen durch den aktiven Dämpfungsmechanismus nicht auf die zu isolierende Last übertragen werden.

Die Regelung kann dabei in mehreren Freiheitsgraden erfolgen. Insbesondere können in allen sechs Raumrichtungen Sensoren und Aktoren verwendet werden. Weiter ist bekannt, bei der Berechnung durch Übertragungsmatrizen von einer Raumrichtung in die andere mit einzuschließen.

Das Dokument US 2003/0090645 A1 zeigt ein Schwingungsisolationssystem, bei dem eine "skyhook stiffness" hinzugefügt wird, wobei die Eigenmoden des Schwingungsisolationsystems erhalten bleiben sollen. Das Dokument US 5,303,155 A beschreibt ein Verfahren zur Regelung des Fahrwerks eines Kraftfahrzeugs.

Aufgabe der Erfindung

Der Erfindung liegt demgegenüber die Aufgabe zugrunde, die Wirksamkeit eines aktiven Schwingungsisolationssystems, insbesondere im unteren Frequenzbereich weiter zu verbessern.

Zusammenfassung der Erfindung

Die Aufgabe der Erfindung wird durch ein Verfahren zur Regelung eines aktiven Schwingungsisolationssystems nach Anspruch 1 gelöst.

Bevorzugte Ausführungsformen und Weiterbildungen der Erfindung sind Gegenstand der abhängigen Ansprüche.

Die Erfindung betrifft ein Verfahren zur Regelung eines aktiven Schwingungsisolationssystems. Dieses umfasst eine auf einem Boden schwingungsisoliert gelagerte Last. Die schwingungsisoliert gelagerte Last kann beispielsweise eine Maschine zur Prozessierung von Wafern sein. Zur schwingungsisolierten Lagerung umfasst das Schwingungsisolationssystem Schwingungsisolatoren. Diese Schwingungsisolatoren sind insbesondere als Luftlager ausgebildet, welche gegebenenfalls auch aktiv angesteuert werden können. Weiter umfasst das Schwingungsisolationssystem eine aktive Regelung mit einer Regeleinrichtung, die anhand des Signals eines Geschwindigkeits- oder Beschleunigungssensors in zumindest einer Raumrichtung einen Aktor ansteuert.

Es ist also ein Sensor, insbesondere ein Geophon oder ein anderer seismischer Sensor vorgesehen, welcher die Geschwindigkeit oder Beschleunigung der zu isolierenden Last in zumindest einer Raumrichtung als absoluten Wert erfasst.

Basierend hierauf steuert die Regeleinrichtung einen zumindest in einer Raumrichtung wirksamen Aktor an. Der Aktor kann beispielsweise als Magnetaktor, insbesondere als Lorenzmotor, ausgebildet sein und insbesondere auch in einem Schwingungsisolator integriert sein.

Vorzugsweise ist die Regelung in mehreren Freiheitsgraden wirksam, insbesondere in je drei lateralen und rotatorischen Freiheitsgraden.

Über Matrizen zur Regelung des Systems können Übertragungsfunktionen in die Regelung einfließen, so dass berücksichtigt wird, dass es oft erforderlich ist, Kopplungen zwischen den Bewegungsrichtungen zu vermeiden.

Gemäß der Erfindung erzeugt die Regeleinrichtung gegenüber einem virtuellen Punkt, also allein auf einen absoluten Geschwindigkeits- oder Beschleunigungswert, im Raum eine Steifigkeit durch Ansteuerung des Aktors.

Der Erfindung liegt mithin die Erkenntnis zugrunde, dass die Wirksamkeit eines nach dem Skyhook-Prinzip arbeitenden Schwingungsisolationssystems dadurch verbessert werden kann, dass neben einer aktiven Dämpfung eine aktive Steifigkeit hinzugefügt wird.

Die aktive Steifigkeit wirkt, als wäre die schwingungsisoliert gelagerte Last über eine Feder mit dem virtuellen Punkt verbunden. Vorzugsweise ist dabei die Kraft proportional zur Auslenkung. Die Regeleinrichtung erzeugt die Steifigkeit durch Erzeugen einer wegproportionalen Kraft.

Der virtuelle Punkt im Sinne der Erfindung erreicht, dass die Steifigkeit nicht mit dem Boden gekoppelt ist (oder über starre oder flexible Verbindungen mit dem Boden verbunden), sondern im Raum ist.

Bei einer bevorzugten Ausführungsform der Erfindung erfolgt zusätzlich gegenüber einem virtuellen Punkt im Raum eine aktive Dämpfung durch Ansteuerung eines Aktors, wie sie bereits nach dem Skyhook-Prinzip bekannt ist. Diese Ausführungsform der Erfindung kombiniert mithin die nach dem Skyhook-Prinzip bekannte aktive Dämpfung mit der erfindungsgemäß nach dem ähnlichen Prinzip arbeitenden aktiven Steifigkeit.

Es hat sich herausgestellt, dass hierdurch die Isolation im tieffrequenten Bereich deutlich verbessert wird. So erreicht das Schwingungsisolationssystem durch die hinzugefügte Steifigkeit in einem Frequenzbereich von unter 15 Hz, vorzugsweise unter 10 Hz und besonders bevorzugt von unter 5 Hz eine geringere Übertragung von Bodenschwingungen, insbesondere wird das Verhältnis von Schwingungsamplituden der zu isolierenden Last gegenüber Bodenschwingungen gegenüber Amplituden der Bodenschwingung (Transmissability-Funktion) im Vergleich zu einer Regelung ohne hinzugefügte Steifigkeit zumindest bereichsweise um mehr als 5 dB reduziert.

Weiter wird gleichzeitig gemäß der Erfindung durch Hinzufügen einer aktiven Steifigkeit die Eigenfrequenz des Schwingungsisolationssystems um zumindest 2 Hz erhöht.

Die Erfindung kann für ein Schwingungsisolationssystem verwendet werden, welches, wie eingangs beschrieben, eine auf dem Boden isolierte schwingungsisoliert gelagerte Last sowie eine aktive Regelung mit einer Regeleinrichtung umfasst, welche anhand eines Signals eines Geschwindigkeits- oder Beschleunigungssensors in zumindest einer Raumrichtung einen Aktor ansteuern kann.

Mittels der Regeleinrichtung ist bei Ansteuerung des Aktors eine Federkraft zu einem virtuellen Punkt im Raum erzeugbar.

Vorzugsweise ist gleichzeitig zu einem virtuellen Punkt eine Dämpfung erzeugbar.

Der Sensor ist insbesondere als Geophon ausgebildet.

Bei Verwendung eines als Geschwindigkeitssensors ausgebildeten Sensors umfasst die Regeleinrichtung bei einer bevorzugten Ausführungsform einen PI-Regler (proportional integrated controller).

Im Falle eines als Beschleunigungssensor ausgebildeten Sensors umfasst die Regeleinrichtung zweckmäßiger einen einfachen und doppelten Integrator, da die Geschwindigkeit durch Integration der Beschleunigung berechnet werden kann. Der einfache Integrator wird dabei die Dämpfung und der doppelte Integrator für die hinzugefügte Steifigkeit verwendet.

Eine Regeleinrichtung für das erfindungsgemäße Schwingungsisolationssystem kann sowohl über digitale Signalprozessoren als auch als analoge Regelung in Form einer elektrischen Schaltung realisiert werden.

Kurzbeschreibung der Zeichnungen

Der Gegenstand der Erfindung soll im Folgenden bezugnehmend auf die Zeichnungen Fig. 1 bis Fig. 6 näher erläutert werden.

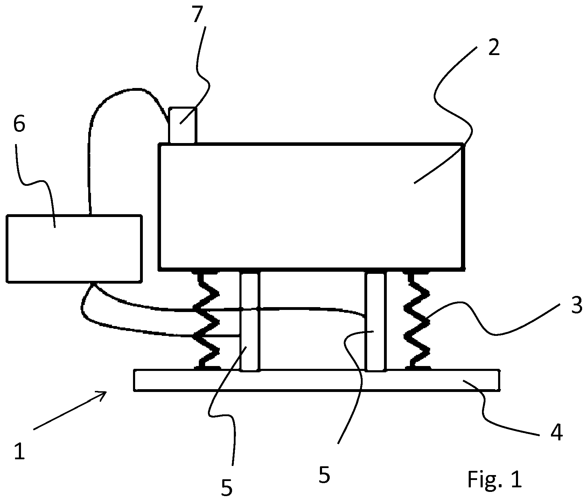

Fig. 1 zeigt das Grundprinzip eines aktiven Schwingungsisolationssystems.

Bezugnehmend auf die Zeichnungen Fig. 2 bis Fig. 3 soll das Funktionsprinzip einer Skyhook-Regelung zur aktiven Dämpfung erläutert werden. Fig. 4 und 5 zeigen das Regelprinzip einer Skyhook-Dämpfung mit zusätzlich hinzugefügter Steifigkeit.

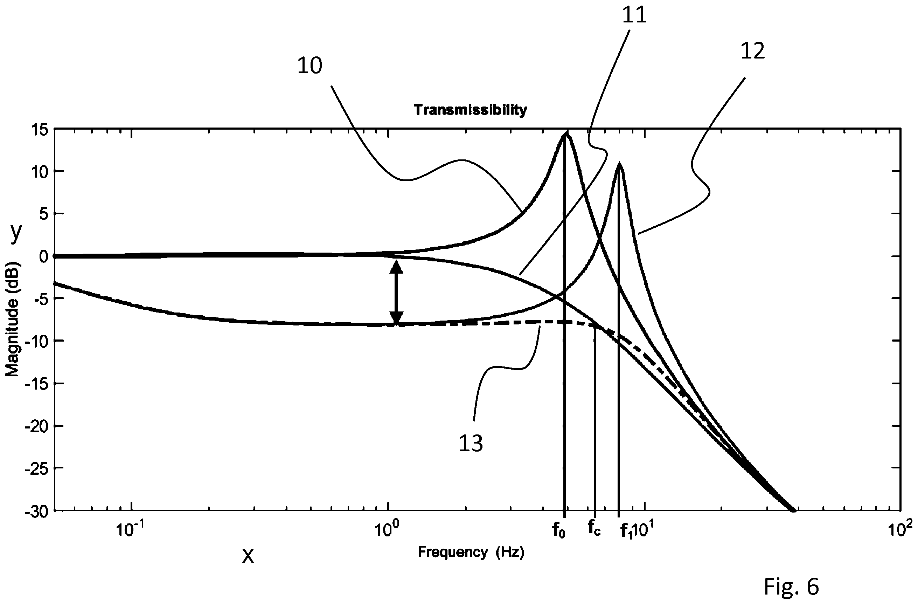

Fig. 6 zeigt die Übertragungskurven verschiedener Regelungskonzepte.

Detaillierte Beschreibung der Zeichnungen

Fig. 1 zeigt eine schematische Ansicht eines aktiven Schwingungsisolationssystems 1.

Dieses umfasst eine schwingungsisoliert gelagerte Last 2, also insbesondere eine Maschine zur Prozessierung von Wafern.

Die schwingungsisoliert gelagerte Last 2 ist über Schwingungsisolatoren 3 auf dem Boden 4 bzw. einem Fundament gelagert.

Die Schwingungsisolatoren 3 sind insbesondere als Luftlager ausgebildet und hier nur schematisch dargestellt.

Das Schwingungsisolationssystem umfasst des Weiteren Aktoren 5 zur aktiven Regelung, welche über eine Regeleinrichtung 6 angesteuert werden. Die Regeleinrichtung 6 ist mit einem an der schwingungsisolierten Last angeordneten Sensor 7 verbunden und steuert auf Basis der Signale des Sensors 7 die Aktoren 5 an. In dieser Ansicht ist der Einfachheit halber nur eine Raumrichtung dargestellt. Es versteht sich aber, dass in der Regel die Regelung in mehreren Raumrichtungen erfolgt.

Der Sensor 7 misst als absoluten Wert die Geschwindigkeit oder Beschleunigung der schwingungsisoliert gelagerten Last 2.

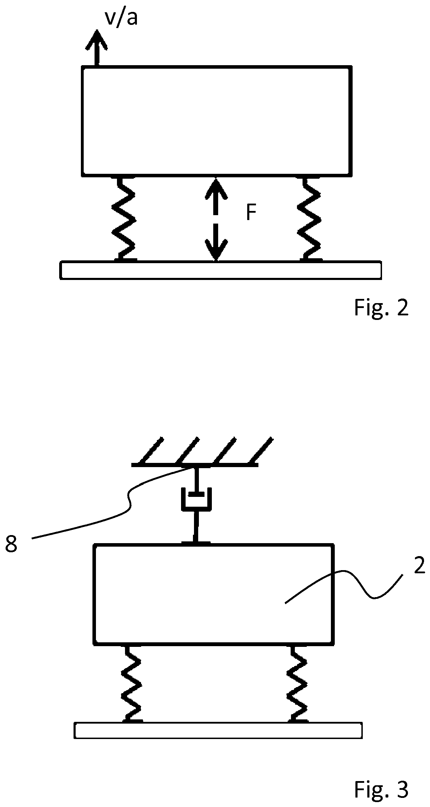

Wie in Fig. 2 schematisch dargestellt, wird über den Sensor die Geschwindigkeit (v) oder die Beschleunigung (a) gemessen und basierend hierauf über die Aktoren eine geschwindigkeitsproportionale Kraft erzeugt.

Falls Aktoren mit integrierendem oder differenzierendem Ansteuerungsverhalten verwendet werden, kann dies durch kompensierende Differenzierung oder Integration berücksichtigt werden.

Bei Verwendung eines Geschwindigkeitssensors, insbesondere eines Geophons, werden P-Regler (Proportionalregler) verwendet, wohingegen bei Beschleunigungssensoren I-Regler (Integralregler) verwendet werden, um die erforderlichen geschwindigkeitsproportionalen Kräfte zu erzeugen.

Es versteht sich, dass die Regelung noch weitere Komponenten, wie insbesondere zusätzliche Filter, wie Hochpass-, Tiefpass-Filter sowie Bandpass-Filter und Bandsperren umfassen kann.

Im Beispiel der Verwendung eines Geschwindigkeitssensors zum Messen der absoluten Geschwindigkeit $v_{abs}$ und einem Aktor, welcher Kräfte proportional zur Stellgröße erzeugt, ergibt sich folgendes Regelgesetz, wobei A die Aktorkonstante ist:

$$F_{Aktorik} = v_{abs} \cdot k_P \cdot A$$

kp ist der P-Anteil des Reglers, so dass eine geschwindigkeitsproportionale Kraft erzeugt wird, was einer aktiven Dämpfung entspricht.

Die Rückkopplung der Aktorkraft auf den Boden kann dabei in der Regel vernachlässigt werden, so dass die Regelung als aktiver Dämpfer gegenüber einem virtuellen Punkt 8 im Raum funktioniert, wie dies in Fig. 3 dargestellt ist. Dort ist die schwingungsisoliert gelagerte Last 2 gegenüber dem virtuellen Punkt 8 gedämpft, was in dieser schematischen Zeichnung als virtueller Dämpfer eingezeichnet ist.

Dieses Regelkonzept erreicht, dass Bewegungen der zu isolierenden Last gedämpft werden, auch wenn diese durch Bewegungen des Bodens auf die zu isolierende Last übertragen werden. Auch Störungen, welche durch die zu isolierende Last, etwa eine Maschine, erzeugt werden, können mit dieser Regelung gedämpft werden.

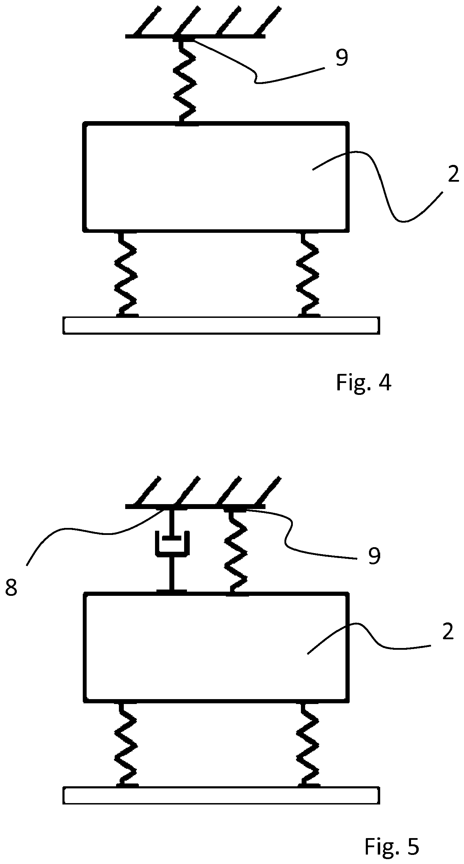

Fig. 4 zeigt die Wirkungsweise der Erfindung.

Im Gegensatz zu einer Skyhook-Dämpfung wird eine Skyhook-Steifigkeit erzeugt. Die zu isolierende Last 2 ist aufgrund des Regelkonzeptes wie über eine Feder zur Fixierung der zu isolierenden Last mit einem virtuellen Punkt 9 im Raum verbunden.

Diese virtuelle Feder wird dadurch erzeugt, dass eine wegproportionale Kraft über die Regelung erzeugt wird. Gegenüber einer aktiven Dämpfung muss der Regler also um einen Integrator (I-Anteil $k_I$) erweitert werden, welcher beispielsweise aus dem Geschwindigkeitssignal ein Wegsignal $q_{abs}$ der zu isolierenden Last 2 erzeugt:

$$F_{Aktorik} = \int v_{abs} dt \ \cdot k_I \cdot A = q_{abs} \cdot k_I \cdot A$$

So entsteht eine aktive Steifigkeit, die vom Aktor erzeugte Kraft ist proportional zur Auslenkung der zu isolierenden Last.

Vorzugsweise werden, wie dies in Fig. 5 dargestellt ist, die aktive Dämpfung mit der aktiven Steifigkeit kombiniert, das heißt die schwingungsisoliert gelagerte Last 2 wird über Aktoren (hier nicht dargestellt) derart angesteuert, dass diese zum einen wie über eine Feder mit einem virtuellen Punkt 9 verbunden ist. Gleichzeitig wird eine Dämpfung gegenüber einem virtuellen Punkt 8 erzeugt.

In dieser Darstellung sind zwei virtuelle Punkte 8, 9 vorhanden, was aber nicht notwendig ist. Es reicht, einen einzelnen zu haben. Auch werden für unterschiedliche Freiheitsgrade und Raumrichtungen keine weiteren Punkte benötigt, da dieser Bezugspunkt nur der Ausgestaltung einer vom Boden abgekoppelten Regelung dient und mithin beliebig platziert sein kann.

Durch die Erfindung kann insbesondere die Schwingungsunterdrückung im unteren Frequenzbereich weiter verbessert werden. Eine Kombination mit aktiver Dämpfung kann beispielsweise dadurch erzielt werden, wenn, wie vorstehend beschrieben, ein PI-Regler verwendet wird. Es ergibt sich dann folgendes Regelgesetz:

$$F_{Aktorik} = \left( \int v_{abs} dt \ \cdot k_I + \ k_P \right) \cdot A = (q_{abs} \cdot k_I + v_{abs} \cdot k_P) \cdot A$$

Die verbesserte Wirkung des erfindungsgemäßen Regelkonzeptes ergibt sich aus Fig. 6.

In Fig. 6 ist die sogenannte Transmissability-Funktion dargestellt, dies ist die Größe der Übertragungsfunktion, die das Verhältnis von Schwingungsamplituden der zu isolierenden Last gegenüber Amplituden der Bodenschwingung darstellt.

Auf der x-Achse ist die Frequenz in Hz (in logarithmischer Darstellung) und auf der y-Achse die Magnitude in dB angegeben. Die Kurve 10 zeigt eine rein passive Dämpfung. Zu erkennen ist, dass mit Erreichen der Eigenfrequenz $f_0$ des Systems die Übertragung ein Maximum erzeugt.

Die Kurve 11 zeigt die Übertragungsfunktion des Systems, welches nunmehr um eine aktive Dämpfung nach dem Skyhook-Prinzip ergänzt wurde. Über einen Proportionalanteil des Reglers kp kann im Bereich der Eigenfrequenz $f_0$ die über Resonanzüberhöhung des passiven Isolationssystems unterdrückt werden. Diese Wirkung ist aber um den Bereich um die Resonanzfrequenz $f_0$ herum limitiert.

Die Kurve 12 zeigt ein System, bei welchem nunmehr eine erfindungsgemäße aktive Steifigkeit hinzugefügt wurde. Zu erkennen ist, dass die Übertragung insbesondere im Bereich unterhalb der Eigenfrequenz $f_0$ reduziert wurde.

Die gestrichelte Kurve 13 zeigt nunmehr eine Kombination aus aktiver Dämpfung und aktiver Steifigkeit.

Die Eigenfrequenz dieses Systems wird durch die aktive Steifigkeit, welche über den Integralanteil des Reglers $k_I$ eingestellt werden kann, von $f_0$ auf $f_1$ erhöht. Zwischen der Frequenz $f_0$ und der Frequenz $f_1$ liegt die Frequenz $f_c$, unterhalb derer die Isolationswirkung des Systems durch das Hinzufügen einer aktiven Steifigkeit verbessert wurde. Es ist zu erkennen, dass unterhalb der Frequenz fc die Isolationswirkung im gesamten Bereich verbessert wurde. Die erfindungsgemäße Regelung wirkt insbesondere in einem niedrigen Frequenzbereich, beispielsweise bei einer Frequenz von unter 10, insbesondere von unter 7 Hz. Zu erkennen ist, dass insbesondere in einem Bereich von unter 5 Hz eine Verbesserung von mehr als 5 dB erreicht wurde.

Im sehr niederfrequenten Bereich, hier in einem Bereich von unter 0,2 Hz, steigt die Magnitude trotz hinzugefügter Steifigkeit wieder an. Dies liegt im vorliegenden Fall an der Verwendung von Hoch- und Tiefpass-Filtern, welche Rausch- und Drifteinflüsse der Sensoren sowie der Aktoren kompensieren.

Alles in allem wird deutlich, dass durch die Erfindung die Wirkung des aktiven Schwingungsisolationssystems, insbesondere im niederfrequenten Bereich, erheblich verbessert werden konnte.

Bezugszeichenliste

1    Schwingungsisolationssystem
2    Last
3    Schwingungsisolator
4    Boden
5    Aktor
6    Regeleinrichtung
7    Sensor
8    virtueller Punkt
9    virtueller Punkt
10   passive Dämpfung
11   aktive Dämpfung
12   aktive Steifigkeit
13   aktive Dämpfung kombiniert mit aktiver Steifigkeit

**Patentansprüche**

1. Verfahren zur Regelung eines aktiven Schwingungsisolationssystems (1), welches eine Maschine zur Prozessierung von Wafern als eine auf einem Boden (4) schwingungsisoliert gelagerte Last (2) sowie eine aktive Regelung mit einer Regeleinrichtung (6) umfasst, welche anhand eines Signals eines Geschwindigkeits- oder Beschleunigungssensors (7) in zumindest einer Raumrichtung einen Aktor (5) ansteuert, wobei die Regeleinrichtung (6) gegenüber einem virtuellen Punkt (9) im Raum eine Steifigkeit durch Ansteuerung des Aktors (5) erzeugt, **dadurch gekennzeichnet dass** durch die Erzeugung der Steifigkeit die Eigenfrequenz des Schwingungsisolationssystems (1) um mindestens 2 Hz erhöht wird.

2. Verfahren zur Regelung eines aktiven Schwingungsisolationssystems (1) nach dem vorstehenden Anspruch, **dadurch gekennzeichnet, dass** die Regeleinrichtung die Steifigkeit durch Bereitstellen einer wegproportionalen Kraft erzeugt.

**3.** Verfahren zur Regelung eines aktiven Schwingungsisolationssystems (1) nach einem der vorstehenden Ansprüche, **dadurch gekennzeichnet, dass** die Regeleinrichtung zusätzlich gegenüber einem virtuellen Punkt (8) im Raum eine aktive Dämpfung durch Ansteuerung eines Aktors (5) erzeugt.

**4.** Verfahren zur Regelung eines aktiven Schwingungsisolationssystems (1) nach einem der vorstehenden Ansprüche, **dadurch gekennzeichnet, dass** die Regeleinrichtung in drei, vorzugsweise in sechs Freiheitsgraden wirksam ist.

**5.** Verfahren zur Regelung eines aktiven Schwingungsisolationssystems (1) nach einem der vorstehenden Ansprüche, **dadurch gekennzeichnet, dass** durch die hinzugefügte Steifigkeit in einem Frequenzbereich von unter 15 Hz, vorzugsweise unter 10 Hz und besonders bevorzugt von unter 5 Hz eine geringere Übertragung von Bodenschwingungen bereit gestellt wird, insbesondere das Verhältnis von Schwingungsamplituden der zu isolierenden Last gegenüber Bodenschwingungen gegenüber Amplituden der Bodenschwingung im Vergleich zu einer Regelung ohne hinzugefügte Steifigkeit zumindest bereichsweise um mehr als 5 dB reduziert wird.

**Claims**

**1.** A method for controlling an active vibration isolation system (1) which comprises a machine for processing wafers as a load (2) mounted with vibration isolation on a floor (4), and an active control using a control device (6) that drives an actuator (5) in at least one spatial direction in response to a signal from a velocity or acceleration sensor (7); wherein, by driving the actuator (5), the control device (6) generates a stiffness relative to a virtual point (9) in space; **characterised in that** the generation of stiffness causes an increase in the natural frequency of the vibration isolation system (1) by at least 2 Hz.

**2.** The method for controlling an active vibration isolation system (1) according to the preceding claim, **characterised in that** the control device generates the stiffness by providing a displacement-proportional force.

**3.** The method for controlling an active vibration isolation system (1) according to any one of the preceding claims, **characterised in that** the control device additionally generates active damping relative to a virtual point (8) in space by driving an actuator (5).

**4.** The method for controlling an active vibration isolation system (1) according to any one of the preceding claims, **characterised in that** the control device is effective in three, preferably six degrees of freedom.

**5.** The method for controlling an active vibration isolation system (1) according to any one of the preceding claims, **characterised in that** the additional stiffness translates into a reduced transfer of vibrations of the floor in a frequency range below 15 Hz, preferably below 10 Hz, and more preferably below 5 Hz, wherein in particular the ratio of vibration amplitudes of the load to be isolated to the amplitude of vibrations of the floor is reduced by more than 5 dB at least in some ranges, compared to a control without additional stiffness.

**Revendications**

**1.** Procédé de régulation d'un système d'isolation vibratoire active (1), qui comprend une machine de traitement de tranches de silicium sous la forme d'une charge (2) isolée vibratoirement sur un sol (4) ainsi que d'une régulation active avec un équipement de régulation (6), lequel commande un actionneur (5) dans au moins une direction spatiale à l'aide d'un signal d'un capteur de vitesse ou d'accélération (7), l'équipement de régulation (6) produisant, par rapport à un point virtuel (9) dans l'espace, une raideur par actionnement de l'actionneur (5), **caractérisé en ce que**, du fait de la raideur produite, la fréquence propre du système d'isolation vibratoire (1) est augmentée d'au moins 2 Hz.

**2.** Procédé de régulation d'un système d'isolation vibratoire active (1) selon la revendication précédente, **caractérisé en ce que** l'équipement de régulation produit la raideur en fournissant une force proportionnelle à la course.

**3.** Procédé de régulation d'un système d'isolation vibratoire active (1) selon une des revendications précédentes, **caractérisé en ce que** l'équipement de régulation produit en plus, par rapport à un point virtuel (8) dans l'espace, un amortissement actif par actionnement d'un actionneur (5).

**4.** Procédé de régulation d'un système d'isolation vibratoire active (1) selon une des revendications précédentes, **caractérisé en ce que** l'équipement de régulation opère avec trois, de préférence avec six degrés de liberté.

**5.** Procédé de régulation d'un système d'isolation vibratoire active (1) selon une des revendications précédentes, **caractérisé en ce que**, du fait de la raideur ajoutée, une moindre transmission des vibrations du sol est obtenue dans une plage de fréquences inférieure à 15 Hz, préférentiellement inférieure à 10 Hz et particulièrement préférentiellement inférieure à 5 Hz, en particulier le rapport entre les amplitudes vibratoires de la charge à isoler des vibrations du sol et les amplitudes de la vibration du sol est abaissé, au moins par endroits, de plus de 5 dB par comparaison à une régulation sans raideur ajoutée.

Fig. 1

Fig. 2

Fig. 3

Fig. 4

Fig. 5

Fig. 6

EP 3 098 654 B1

**IN DER BESCHREIBUNG AUFGEFÜHRTE DOKUMENTE**

**In der Beschreibung aufgeführte Patentdokumente**

- US 20030090645 A1
- US 5303155 A